# FASCICULE DE BREVET EUROPEEN

(11) **EP 2 834 189 B1**
(45) Date de publication et mention de la délivrance du brevet: **28.07.2021**
(21) Numéro de dépôt: 13713439.1
(22) Date de dépôt: 29.03.2013
(51) Int. Cl.: B82Y 10/00, B82Y 99/00, H01L 31/0224, H01L 31/0352, H01L 33/04, H01L 33/24, H01L 33/38, H01L 33/00, H01L 33/08, H01L 33/18, H01L 33/32, H01L 33/40, H01L 33/46, B82Y 20/00, B82Y 40/00

(54) **STRUCTURE SEMICONDUCTRICE OPTOELECTRONIQUE A NANOFILS ET PROCEDE DE FABRICATION D'UNE TELLE STRUCTURE**
OPTOELEKTRONISCHE HALBLEITERSTRUKTUR MIT NANODRÄHTEN UND VERFAHREN ZUR HERSTELLUNG EINER SOLCHEN STRUKTUR
OPTOELECTRONIC SEMICONDUCTING STRUCTURE WITH NANOWIRES AND METHOD OF FABRICATING SUCH A STRUCTURE

(30) Priorité: 02.04.2012 FR 1253011
(43) Date de publication de la demande: 11.02.2015
(73) Titulaire: Commissariat à l'Énergie Atomique et aux Énergies Alternatives, 75015 Paris (FR)
(72) Inventeur: POUGEOISE, Emilie, 38000 Grenoble (FR); BAVENCOVE, Anne-Laure, 38000 Grenoble (FR); VANDENDAELE, William, 38100 Grenoble (FR)
(74) Mandataire: Brevalex
(86) Numéro de dépôt international: PCT/EP2013/056816
(87) Numéro de publication internationale: WO 2013/149964

(56) Documents cités:
- WO-A1-2010/089623
- WO-A1-2012/035243
- WO-A2-2011/156266
- US-A1- 2009 124 053
- US-A1- 2010 276 664
- None

## Description

### DOMAINE TECHNIQUE

L'invention se rapporte au domaine de la détection, de la mesure et de l'émission de rayonnement électromagnétique et aux dispositifs permettant la détection, la mesure ou l'émission de rayonnements électromagnétiques.

Ces dix dernières années ont été marquées par un fort développement de l'optoélectronique et des dispositifs qui en découlent. De tels dispositifs mettent en œuvre des structures semiconductrices qui sont adaptées pour la détection, la mesure ou l'émission de rayonnements électromagnétiques.

Parmi ces structures, les structures semiconductrices à base de nanofils démontrent un fort potentiel quant aux rendements atteignables que ce soit pour la réception, dans le cas de la détection et la mesure, ou l'émission, de rayonnements électromagnétiques. Ces rendements sont également suffisamment importants pour envisager l'utilisation de telles structures dans les applications photovoltaïques.

De telles structures, qu'elles soient dédiées à la détection, la mesure ou l'émission d'un rayonnement électromagnétique ou aux applications photovoltaïques, peuvent être dénommées plus généralement structures optoélectroniques.

On entend donc ci-dessus et dans le reste de ce document par structure optoélectronique tout type de structures semiconductrices adaptées pour effectuer la conversion d'un signal électrique en un rayonnement électromagnétique ou inversement.

L'invention se rapporte plus particulièrement à un procédé de fabrication d'une structure semiconductrice optoélectronique et à une structure semiconductrice optoélectronique.

### ÉTAT DE LA TECHNIQUE ANTÉRIEURE

Le développement industriel et la commercialisation des structures optoélectroniques à base de nanofils restent encore très limités en raison d'un certain nombre de barrières technologiques.

Parmi ces barrières technologiques, on peut citer notamment les pertes électriques liées à la connexion et la polarisation des nanofils.

En effet, une structure semiconductrice optoélectronique à base de nanofils comporte généralement :
- un substrat semiconducteur comportant une première et une seconde face, le substrat présentant une concentration en porteurs majoritaires suffisante pour autoriser une polarisation de qualité,
- une couche de nucléation adaptée pour la croissance de nanofils,
- plusieurs nanofils en contact par leur base avec la couche de nucléation, les nanofils comportant une zone active adaptée pour effectuer la conversion d'un signal électrique en un rayonnement électromagnétique ou inversement,
- un premier contact électrique agencé sur la seconde face du substrat pour polariser le substrat,
- un deuxième contact électrique en contact avec chacun des nanofils au niveau de leur extrémité qui est opposée à la base.

Ainsi, avec une telle structure, la polarisation de la zone active de chacun des nanofils est obtenue en appliquant une différence de potentiel entre le premier et le deuxième contact. Cette polarisation de la zone active permet, en fonctionnement et pour une structure optoélectronique, la conversion d'un signal électrique en un rayonnement électromagnétique ou inversement.

Si une telle structure autorise aux moyens du premier et du deuxième contact électrique une polarisation de la zone active de chacun des nanofils, elle présente néanmoins des pertes électriques non négligeables au niveau des interfaces substrat/couche de nucléation/nanofils.

En effet, les matériaux formant le substrat, la couche de nucléation et la base des nanofils sont généralement des semiconducteurs de différentes natures et forment à chaque interface une hétérostructure. Un tel type d'interface présente généralement une forte résistance d'interface.

Ceci est particulièrement le cas lorsque les nanofils comportent une base en nitrure semiconducteur. En effet, pour ce type de nanofils la couche de nucléation est en nitrure d'aluminium (AIN) qui est un semiconducteur grand gap (l'énergie de sa bande interdite étant supérieure à 6 eV) qui se comporte comme un « semi-isolant ». Les interfaces substrat/couche de nucléation et couche de nucléation/ nanofils présentent donc, avec un tel matériau formant la couche de nucléation, une forte résistance d'interface. Il en résulte que la polarisation de la base de chaque nanofil par l'interface substrat/nanofil entraîne des pertes électriques importantes liées principalement à la présence de la couche de nucléation.

Une telle structure nécessite donc des tensions de polarisation plus importantes pour compenser les pertes au niveau de cette interface et présente un rendement réduit puisqu'amputées par lesdites pertes.

On peut noter que dans le cas d'une structure du type photovoltaïque, si la zone active ne nécessite pas de polarisation, les premier et deuxième contacts sont présents pour la connexion de la structure afin de collecter l'énergie produite au niveau de la zone active, la problématique des pertes au niveau de l'interface substrat/nanofils est donc également présente pour une structure de type photovoltaïque.

WO 2011/156266 divulgue une structure semiconductrice optoélectronique selon le préambule de la revendication 1.

### EXPOSÉ DE L'INVENTION

La présente invention vise à remédier à cet inconvénient.

Un but de l'invention est de fournir une structure semiconductrice optoélectronique à base de nanofils comportant une couche de nucléation présentant une bande interdite d'énergie supérieure à 5 eV, la structure présentant une résistance d'interface entre le substrat et chacun des nanofils qui est réduite vis-à-vis d'une structure de l'art antérieur comportant une telle couche de nucléation.

Un autre but de l'invention est de fournir une structure semiconductrice optoélectronique à base de nanofils comportant une couche de nucléation, la structure présentant une optimisation de l'évacuation de la chaleur produite par les zones actives de chacun des nanofils lors du fonctionnement de la structure.

A cet effet, l'invention concerne une structure semiconductrice optoélectronique comportant :
- un substrat semiconducteur présentant une première et une seconde face,
- une couche de nucléation en contact avec la première face du substrat, la couche de nucléation étant un semiconducteur grand gap dont l'énergie de bande interdite est supérieure à 5 eV,
- un nanofil en contact avec la couche de nucléation,
la couche de nucléation étant formée d'au moins un plot et recouvrant la première face du substrat sur une partie de la première face qui est dite de nucléation, la partie de la première face non recouverte par la couche de nucléation étant dite partie libre, la structure comportant en outre une couche conductrice en contact avec la partie libre du substrat, ladite couche conductrice étant également en contact avec le nanofil sur le pourtour du nanofil.

Une telle couche conductrice, de par son contact avec à la fois le substrat et le nanofil, permet de polariser le nanofil en parallèle avec le contact fourni par la couche de nucléation. Ainsi, pour un contact fourni par la couche de nucléation au travers des interfaces substrat/couche de nucléation/nanofil présentant de fortes pertes électriques, la polarisation du nanofil est essentiellement obtenue par l'intermédiaire de la couche conductrice et les pertes électriques liées aux interfaces substrat/couche conductrice et couche conductrice/nanofil s'en trouvent réduites. Il en résulte des pertes électriques réduites pour l'interface substrat/nanofil par rapport à une structure de l'art antérieur pour laquelle la polarisation est uniquement fournie par la couche de nucléation.

De plus une telle couche conductrice présente, en raison de la conduction thermique par ces porteurs majoritaires, des propriétés de conduction thermique qui permettent d'évacuer une partie de la chaleur produite par les zones actives lors du fonctionnement de la structure.

L'invention concerne donc une structure dont la couche de nucléation est un semiconducteur grand gap dont l'énergie de bande interdite est supérieure à 5 eV.

La couche conductrice peut être en contact avec tout le pourtour du nanofil.

Selon l'invention la partie libre de la première face est en retrait par rapport à la partie de nucléation ceci sur une hauteur de retrait qui est comprise entre 1nm et 5µm, la dite hauteur de retrait étant préférentiellement comprise entre 1nm et 500nm.

Un tel retrait de la partie libre de la première face permet d'augmenter la partie de la couche de conduction qui peut être en contact avec le substrat, celle-ci pouvant être en contact avec le substrat sur la partie libre et sur les parois créées par le retrait de la partie libre. On obtient ainsi une interface électrique entre la couche conductrice et le substrat optimisée et donc une faible résistance de contact entre la couche conductrice et le substrat. La résistance de contact entre le nanofil et la couche conductrice étant également faible en raison du contact de cette dernière avec le pourtour du nanofil, il en résulte une interface électrique optimisée, et donc une résistance d'accès réduite, entre le substrat et le nanofil vis-à-vis d'une structure ne présentant pas un tel retrait de la partie libre de la première face.

Le nanofil peut recouvrir sensiblement la totalité de la couche de nucléation.

Ainsi la surface de la partie de nucléation de la première face est réduite à son maximum offrant une surface de la partie libre qui est maximisée. On obtient ainsi une surface de la première face sur laquelle la couche de conduction peut être en contact qui est maximum.

La couche de nucléation pouvant être formée d'un plot correspondant au nanofil, le nanofil recouvre ledit plot.

Le nanofil peut être en contact sur la couche de nucléation selon un plan sensiblement parallèle à la première face du substrat en présentant une dimension latérale maximale de la zone du nano fil qui est en contact avec la couche de conduction, la couche conductrice étant en contact avec le nanofil sur une hauteur de contact qui est au moins égale à la dimension latérale maximale divisée par quatre.

Une telle hauteur de contact permet de garantir que la surface de la couche conductrice qui est en contact avec la périphérie du nanofil est suffisante pour fournir un abaissement optimisé de la résistance d'interface entre le nanofil et le substrat par rapport à une structure de l'art antérieur.

La section transversale du nanofil au niveau de sa zone qui est en contact avec la couche conductrice peut être sensiblement circulaire, hexagonale, triangulaire, carrée ou toute forme similaire, la dimension latérale maximale d'un tel nanofil étant le diamètre ou largeur d'une telle section transversale.

La couche conductrice peut être principalement réalisée en un matériau réfractaire ou d'un alliage réfractaire

Un tel matériau réfractaire permet de garantir la tenue de la couche conductrice aux différentes étapes de recuit nécessaires pour la fabrication de la structure sans en affecter les caractéristiques de conductivité, ceci sans qu'il soit nécessaire d'adapter les étapes de fabrication.

La couche conductrice peut être principalement réalisée en un matériau sélectionné dans le groupe comportant le titane (Ti), le tungstène (W), le nickel (Ni) et les alliages comportant lesdits métaux.

De tels matériaux présentent les qualités nécessaires pour former une couche conductrice de bonne qualité et présentent en outre l'avantage de pouvoir former avec le substrat, lorsque celui-ci est du silicium, un siliciure réduisant ainsi la résistance d'interface entre le substrat et la couche conductrice.

La structure peut être une structure d'un type sélectionné dans le groupe comportant les structures adaptées pour émettre un rayonnement électromagnétique, les structures adaptées pour recevoir un rayonnement électromagnétique et le transformer en un signal électrique et les structures du type photovoltaïque.

De telles structures présentent des rendements optimisés puisque les pertes électriques au niveau de l'interface substrat/nanofil sont limitées par la présence de la couche conductrice.

Il peut en outre être prévu un premier contact électrique en contact avec le substrat et un deuxième contact électrique en contact électrique avec le nanofil sur une extrémité de ce dernier qui est opposée au substrat, ceci de manière à autoriser une polarisation du nanofil.

La structure semiconductrice peut être destinée à émettre un rayonnement électromagnétique, la structure comprenant :
- un substrat semiconducteur comportant une première et une seconde face,
- une couche de nucléation, formée d'au moins un plot, sur la première face du substrat recouvrant, ladite couche de nucléation recouvrant une partie de la première face dite de nucléation, le reste de la première face étant dit partie libre,
- au moins un nanofil semiconducteur présentant une zone active adaptée pour émettre un rayonnement électromagnétique lorsqu'elle est polarisée,
- une couche conductrice en contact avec la première face du substrat sur sa partie libre, une couche de masquage étant en contact avec le nanofil sur une partie de son pourtour.

La structure semiconductrice peut être apte à recevoir un rayonnement électromagnétique et à le convertir en un signal électrique, la structure comprenant :
- un substrat semiconducteur comportant une première et une seconde face,
- une couche de nucléation en contact avec la première face du substrat,
- une couche de masquage comportant au moins un orifice traversant et débouchant sur la couche de nucléation,
- au moins un nanofil semiconducteur dans chacun des orifices, en contact avec la première face du substrat, le nanofil présentant en outre une zone active adaptée pour recevoir un rayonnement électromagnétique et le convertir en un signal électrique,
la structure comportant en outre une couche conductrice en contact avec la première face du substrat sur sa partie libre, la couche de masquage étant en contact avec le nanofil sur une partie de son pourtour.

La structure peut comporter des moyens de connexion du nano-fil, un premier moyen de connexion étant agencé pour connecter électriquement au moins une partie du substrat comprenant la partie libre de la première face, un deuxième moyen de connexion étant agencé pour connecter électriquement le nanofil au moins au niveau d'une extrémité du nanofil qui est opposée à la première face du substrat.

L'invention concerne également un procédé de fabrication d'une structure semiconductrice optoélectronique comportant au moins un nanofil semiconducteur, ledit procédé comportant les étapes consistant à:
- fournir un substrat semiconducteur présentant une première et une seconde face,
- former une couche de nucléation, formée d'au moins un plot, en contact avec première face du substrat sur une partie dite de nucléation de cette même première face, la partie de la première face non recouverte par la couche de nucléation étant dite partie libre,
- former une couche conductrice en contact avec la partie libre de la première face,
- former au moins un nanofil avec une partie du nanofil, dite de contact, qui est en contact avec le plot de la couche de nucléation, le nanofil étant en contact avec la couche conductrice.

Un tel procédé permet, de par l'étape de formation de la couche de conduction, la fabrication d'une structure à base de nanofils comportant une couche de nucléation, qui présente une tension de fonctionnement réduite vis-à-vis d'une structure de l'art antérieure ne comportant pas de couche de conduction.

L'invention concerne également une étape de gravure de la partie libre de la première face de façon à ce que la partie libre de la première face soit en retrait d'une hauteur de retrait par rapport à la partie de nucléation de cette même première face, ladite hauteur de retrait étant comprise entre 1nm et 5µm et étant préférentiellement comprise entre 1nm et 500nm.

Une telle étape de gravure de la partie libre permet de fournir une surface de contact plus importante lors de la formation de la couche de conduction assurant ainsi la possibilité à la structure obtenue par le procédé de présenter une résistance d'interface réduite par rapport à une structure dont le procédé de fabrication ne comporte pas une telle étape de gravure.

L'étape de formation de la couche de nucléation peut comprendre les sous-étapes consistant à :
- former une couche de nucléation sur l'ensemble de la première face,
- graver sélectivement une partie de la couche nucléation de manière à libérer la partie libre de la première face du substrat.

De telles sous-étapes permettent la formation de la couche de nucléation sur l'ensemble de la première face du substrat avec le ménagement de la partie libre postérieurement à la formation de la couche de nucléation.

L'étape de gravure de la partie libre de la première face et la sous-étape de gravure sélective d'une partie de la couche de nucléation peuvent être effectuées lors d'une unique étape de gravure.

Une telle étape de gravure permet, en une seule étape, à la fois de donner la forme de la couche de nucléation en libérant la partie libre et de former le retrait de la partie libre qui autorise une optimisation du contact entre la partie libre et la couche conductrice lors de l'étape de formation de la couche conductrice.

L'étape de formation d'au moins un nanofil peut comprendre les sous-étapes consistant à :
- former une couche dite de masquage sur la couche conductrice,
- former un orifice dans la couche de masquage et dans une partie de la couche conductrice, ledit orifice débouchant sur la couche de nucléation pour révéler le plot,
- former un nanofil par croissance sélective sur le plot de la couche de nucléation sur laquelle débouche l'orifice.

Une telle étape de formation du nanofil permet, pour une couche de conduction qui n'est pas adaptée pour une croissance sélective du nanofil, de former un nanofil en présentant un contact périphérique avec la couche de conduction.

L'étape de formation d'au moins un nanofil peut comprendre les sous étapes consistant à :
- former un orifice dans la couche conductrice, ledit orifice débouchant sur la couche de nucléation pour révéler le plot,
- former un nanofil par croissance sélective sur le plot de la couche de nucléation.

Une telle étape de formation du nanofil permet de former un nanofil qui présente un contact périphérique avec la couche de conduction ceci sans nécessiter la formation préalable de couche de masquage, la couche de conduction étant adaptée pour permettre une croissance sélective du nanofil sur la couche de nucléation.

L'étape de formation d'au moins un nanofil peut comprendre les sous-étapes consistant à :
- former, avant l'étape de gravure de la partie libre de la première face et d'une partie de la couche de nucléation, une couche tampon sur la couche de nucléation, ladite couche tampon étant gravée avec la couche de nucléation et la partie libre de la première face,
- former, après l'étape de formation de la couche conductrice, d'une couche dite de masquage sur la couche conductrice,
- former un orifice dans la couche de masquage et dans une partie de la couche conductrice, ledit orifice débouchant sur la couche tampon,
- former un nanofil par croissance sélective sur la partie de la couche de tampon sur laquelle débouche l'orifice.

La formation d'une couche tampon sur la couche de nucléation avant l'étape de formation du nanofil, ledit nanofil comportant la partie de la couche tampon correspondante, permet de fournir un nanofil de bonne qualité. En effet, un tel nanofil présente une base formée de ladite partie de couche tampon qui présente la qualité d'une couche « 2D », le reste du nanofil étant également de qualité puisque formé à partir d'une couche particulièrement adaptée qu'est la couche tampon

L'étape de formation du nanofil comporte les sous étapes consistant à :
- former une première zone du nanofil longitudinale, ladite zone étant sensiblement transversale à la première face du substrat, ladite première zone présentant une composition adaptée pour inhibée la croissance latérale des matériaux destinés à former le reste du nano-fil,
- former le reste du nanofil.

L'étape de formation du nanofil étant une étape de formation d'un nanofil en nitrure semiconducteur, tel que du GaN, ladite première zone peut comporter du silicium de manière à adapter la dite première zone pour inhibée la croissance latérale des matériaux destinés à former le reste du nano-fil.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre un exemple d'une structure semiconductrice selon un premier mode de réalisation,
- la figure 2 illustre sur une vue rapprochée d'une partie de la structure de la figure 1 les différentes dimensions caractéristiques de ladite structure,
- les figures 3A à 3H illustrent les différentes étapes de fabrication de la structure semiconductrice illustrée sur la figure 1,
- la figure 4 illustre une structure semiconductrice selon un deuxième mode de réalisation dans lequel la structure semiconductrice comporte une couche tampon,
- la figure 5 illustre une structure semiconductrice selon un troisième mode de réalisation dans lequel chacun des nanofils comporte une zone active du type axiale,
- La figure 6 illustre une structure semiconductrice selon un quatrième mode de réalisation dans lequel la structure ne comporte pas de couche de masquage et dans lequel la partie de contact de chacun des nanofils comporte au niveau de sa zone de contact avec la couche de nucléation une première zone adaptée pour inhiber la croissance latérale.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

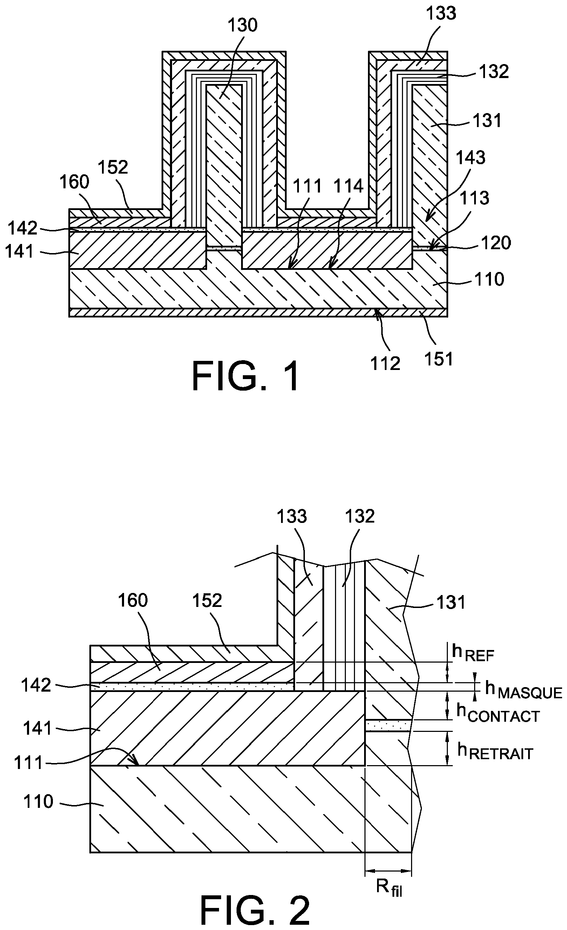

La figure 1 illustre schématiquement une structure 100 semiconductrice selon un premier mode de réalisation de l'invention. La structure 100 illustrée sur la figure 1 est plus précisément une structure semiconductrice adaptée pour une application particulière qui est l'émission d'un rayonnement électromagnétique dont la longueur d'onde est comprise dans la gamme du visible, c'est-à-dire entre 400 et 800nm.

Les caractéristiques et les valeurs qui sont mentionnées dans le reste de ce document, quant il est fait mention de l'application particulière, concernent uniquement cette application et ne limitent en rien les domaines d'application de l'invention.

Une telle structure 100 semiconductrice comporte :
- un substrat 110 semiconducteur présentant une première et une seconde face 111, 112,
- une couche de nucléation 120, formée de plots, en contact avec la première face du substrat et recouvrant une partie 113 de la première face 111 qui est dite de nucléation, le reste 114 de la première face étant dit partie libre,
- une couche conductrice 141 en contact avec la première face 111 du substrat 110,
- une couche de masquage 142 en contact avec la surface de la couche conductrice 141 qui est opposée au substrat 110, lesdites couches conductrice 141 et de masquage 142 comportant des orifices 143 débouchant sur les plots de la couche de nucléation 120,
- des nano-fils 130 en contact chacun avec un plot de la couche de nucléation 120 au travers, pour chacun, de l'orifice 143 correspondant, lesdits nanofils s'étendant au travers de la couche conductrice 141 et la couche de masquage 142, les nanofils 130 comportant chacun une zone active 132,
- une couche réflectrice 160 formée sur la couche de masquage 142 et adaptée pour réfléchir un rayonnement électromagnétique émis par les zones actives 132 des nanofils 130,
- un premier contact électrique 151 en contact électrique avec la deuxième face 112 du substrat 110,
- un deuxième contact électrique 152 en contact électrique avec chacun des nanofils 130.

On entend ci-dessus et dans l'ensemble de ce document par nanofils semiconducteurs des structures semiconductrices présentant trois dimensions, dont deux sont du même ordre de grandeur comprises entre une 5nm et 2,5µm, la troisième dimension étant au moins égale à 2 fois, ou 5 fois, ou plus préférentiellement 10 fois la plus grande des deux autres dimensions.

Le rayon R_{fil} de chacun des nanofils 130 peut être défini par la dimension latérale maximale des orifices 143 divisée par deux.

La figure 2 illustre les valeurs des différentes épaisseurs et hauteurs des couches composant la structure selon le premier mode de réalisation.

Le substrat 110 est un substrat semiconducteur adapté pour la croissance des nanofils 130. Il présente une forme générale sensiblement plane.

Le substrat 110 est un substrat semiconducteur qui permet la conduction des porteurs majoritaires, tel qu'un substrat en silicium Si, en carbure de silicium SiC, en oxyde de zinc ZnO ou en germanium Ge, ou est un substrat métallique.

Le substrat 110 présente un premier type de conductivité. Pour limiter les pertes électriques liées à la résistance électrique entre le substrat 110 et les nanofils 130, le substrat 110 présente une forte concentration de porteurs majoritaires.

Ainsi selon l'application particulière illustrée sur la figure 1, le substrat 110 étant un substrat silicium dont le type de conductivité présente des porteurs majoritaires qui sont des électrons, la concentration en porteurs majoritaires peut être choisie comme étant de l'ordre de 10¹⁹ cm⁻³.

Le substrat 110 présente sur sa première face 111 la partie libre 114 qui est en retrait par rapport à la partie de nucléation 113. Les parties de nucléation 113 et libre 114 sont respectivement les parties de la première face 111 du substrat 110 qui sont en contact avec la couche de nucléation 120 et qui ne le sont pas.

La profondeur du retrait hᵣₑₜᵣₐᵢₜ, comme illustré sur la figure 2, de la partie libre 114 par rapport à la partie de nucléation est comprise entre 0 et 5µm, et est de préférence compris entre 1nm et 500nm.

Le substrat présente sur sa deuxième face le premier contact électrique 151.

Le premier contact électrique 151 prend la forme d'une couche métallique adaptée pour polariser le substrat 111. Le premier contact électrique 151 est, pour l'application particulière, réalisé en un métal apte à former un siliciure avec le silicium. Le premier contact forme un premier moyen de polarisation adapté pour polariser le substrat.

La structure 100, pour limiter la concentration en défauts cristallins des nanofils 130, comporte la couche de nucléation 120 qui est formée dans un matériau adapté pour la croissance des nanofils 130. La couche de nucléation 120 permet de résorber une partie de la différence de maille cristalline qui peut exister entre le matériau constituant le substrat 110 et le matériau de la partie des nanofils 130 en contact avec la première face 111 du substrat 110. Un tel matériau est, pour la partie des nanofils 130 en contact avec le substrat 110 qui est en nitrure semiconducteur, tel que le nitrure de gallium (GaN), le nitrure d'aluminium (AIN).

La couche de nucléation 120 est, plus généralement, un semiconducteur grand gap dont l'énergie de bande interdite est supérieure à 5 eV tel que du nitrure d'aluminium AIN ou le nitrure de bore BN. De tels matériaux sont particulièrement adaptés pour la croissance de nanofils dont la partie de contact est réalisée en nitrure de gallium GaN ou en oxyde de Zinc ZnO.La couche de nucléation 120 est formée de plots.

On entend par plot, ci-dessus et dans le reste de ce document, une zone de la couche de nucléation indépendante des autres zones dont les dimensions latérales sont relativement faibles vis-à-vis de celles de la surface sur laquelle il est positionné, et du même ordre de grandeur l'une de l'autre.

Ici, les dimensions latérales de chacun des plots sont adaptées pour la formation d'un nanofil et est donc en conformation avec les deux dimensions les plus faibles du nanofil correspondant. Ainsi dans le cas d'un nanofil de diamètre de 50 nm, un plot est une zone de la couche de nucléation présentant un diamètre de 50 nm.

La couche conductrice 141 est en contact avec la première face 111 du substrat 110 sur sa partie libre 114. La couche conductrice 141 présente une forme sensiblement plane dans laquelle est partiellement ménagés, sur l'épaisseur de la couche conductrice h_{contact}, les orifices 143.

La couche conductrice 141 est une couche réalisée en un matériau conducteur. La couche conductrice 141 est préférentiellement réalisée en un matériau réfractaire.

Dans le cas où le substrat 110 est en silicium, tel que par exemple le cas de l'application particulière, le matériau de la couche conductrice 141 est préférentiellement un matériau formant avec le silicium un siliciure. Dans ce dernier cas le matériau dont est réalisé la couche conductrice 141 peut être sélectionné dans le groupe comportant titane (Ti), le tungstène (W), le nickel (Ni) le Cobalt, le Pt, le Pd, et les alliages comportant lesdits métaux.

L'épaisseur de la couche conductrice 141 est supérieure à la profondeur de retrait hᵣₑₜᵣₐᵢₜ de la partie libre 114 de la première face 111 du substrat 110, de cette manière la couche conductrice 141 fait saillie de la première surface 111 sur une hauteur qui est dite hauteur de contact h_{contact}, comme illustré sur la figure 2. La valeur de la hauteur de contact h_{contact} correspond à la différence entre l'épaisseur de la couche conductrice 141 et la profondeur de retrait hᵣₑₜᵣₐᵢₜ.

La hauteur de contact est préférentiellement supérieure ou égale au rayon des nano-fils R_{fil} divisé par deux. Une telle dimension permet de fournir une hauteur sur laquelle la couche conductrice 141 est en contact avec chacun des nanofils 130 dont la surface est égale à la surface de la base des nanofils 130.

La couche de masquage 142 s'étend à la surface de la couche conductrice 141 qui est opposée au substrat 110. La couche de masquage 142 présente une forme sensiblement plane dans laquelle est ménagée, sur toute l'épaisseur de la couche de masquage 142, la partie de chacun des orifices 143 qui n'est pas ménagée dans la couche conductrice 141.

La couche de masquage 142 est réalisée dans un matériau sur lequel le ou les éléments composant les nanofils 130 ne se déposent pas lors d'une croissance épitaxiale. Le matériau formant la couche de masquage 142 est préférentiellement un isolant. La couche de masquage 142 peut être, pour des nanofils 130 de nitrure de gallium (GaN), du nitrure de silicium (Si₃N₂), ou du dioxyde de silicium (SiO₂). L'épaisseur h_{masque} de la couche de masquage, comme illustré sur la figure 2, peut être comprise entre 1nm et 1µm.

Ainsi la couche conductrice 141 et la couche de masquage 142 présentent les orifices 143 qui accueillent chacun un des nanofils 130.

Chaque orifice 143 débouche sur un plot de la couche de nucléation 120.

Chaque orifice 143 présente une section transversale par rapport à la couche conductrice qui peut être sensiblement circulaire, hexagonale, triangulaire, carrée ou toute forme similaire. La dimension latérale maximale d'un tel orifice, qui correspond à celle du nanofil correspondant est le diamètre ou largeur d'une telle section transversale.

Chacun des nanofils 130 est une nano-structure semiconductrice allongée dans la direction sensiblement perpendiculaire à la première face 111 du substrat 110. Chaque micro- ou nanofil 130 présente une forme générale cylindrique allongée. Le rayon R_{fil}, comme illustré sur la figure 2, de chacun des nanofils 130 est choisi en fonction de l'application de la structure 100 semiconductrice les comportant. Par exemple, dans l'application particulière illustrée sur la figure 1, le rayon de chaque nanofil 130 est d'environ 500nm.

La hauteur de chacun des nanofils 130 est supérieure à au moins 2, voire 5 fois ou 10 fois le diamètre du nanofil 130. La hauteur de chacun des nanofils 130 peut être comprise entre 100nm et 30µm.

Chaque nanofil 130 comporte une partie, dite de contact, en contact avec la couche de nucléation 120, une zone active 132 en contact avec la partie de contact 131 et une partie 133, dite de polarisation en contact avec la zone active 132.

La partie de contact 131 de chaque nanofil 130 est en contact avec la première face du substrat 110. La partie contact 131 de chaque nanofil 130 est également en contact sur la totalité de son pourtour avec la couche de conductrice 141. Le contact électrique entre la couche conductrice 141 et la partie contact 131 de chaque nanofil 130 est réalisé, comme indiqué plus haut, sur l'épaisseur de la couche conductrice correspondant à l'hauteur de contact h_{contact}. La partie de contact 131, comportant la base du nanofil 130 correspondant, comme illustré sur la figure 1, représente la majeure partie du nanofil 130 correspondant.

Chacune des parties de contact 131 est principalement réalisée en un matériau semiconducteur à gap direct du premier type de conductivité. Le matériau semiconducteur composant la partie de contact 131 de chacun des nanofils 130 est adapté en fonction de l'application de la structure 100 semiconductrice comportant les nanofils 130. Ainsi, en fonction des applications visées, le matériau composant chacune des parties de contact 131 peut être sélectionné dans le groupe comportant, le nitrure de gallium (GaN), le nitrure d'aluminium (AIN), le nitrure d'indium (InN), les nitrures d'indium-gallium du type InₓGa₁₋ₓN et l'oxyde de zinc (ZnO).

On peut noter que, l'invention est particulièrement adaptée pour des nanofils comportant une partie de contact en nitrure d'aluminium AIN ou en nitrure de zinc ZnO.

Pour l'application particulière illustrée sur la figure 1, le matériau semiconducteur composant la partie de contact de chacun des nanofils est le nitrure de gallium (GaN).

Ainsi dans l'application particulière illustrée sur la figure 1, chaque partie de contact 131 est en nitrure de gallium (GaN) et présente une concentration en porteurs majoritaires qui est comprise entre 1x10¹⁸ et 5x10¹⁸ cm⁻³.

Chacune des zones actives 132 est en contact avec la partie de contact 131 du nanofil 130 correspondant. Chaque zone active 132 est une couche recouvrant la partie de contact 131 sur une partie du pourtour et sur l'extrémité de la partie de contact 131 correspondante, ladite extrémité de la partie de contact 131 étant celle qui est opposée à la couche de nucléation 120. Une telle configuration des zones actives 132 dans laquelle elles sont en contact avec à la fois avec une extrémité et le pourtour de la partie de contact 131 correspondante est dite coquille.

Chaque zone active 132 comporte une jonction semiconductrice. La zone active 132, pour une application dans laquelle la structure 100 est adaptée pour l'émission d'un rayonnement électromagnétique, peut, afin d'augmenter le rendement d'émission de chacun des nanofils 130, comporter des moyens de confinement, tels que des puits quantiques multiples.

Dans l'application particulière illustrée sur la figure 1, la zone active 132 est formée de nitrure de gallium et d'indium sous la forme InₓGaₓ₋₁N. Selon cette application particulière, les puits quantiques multiples sont obtenus en alternant sur l'épaisseur de la zone active 132 deux compositions relatives différentes d'indium In et de gallium Ga.

Les zones actives 132 en tant que telles étant bien connues de l'homme du métier, elles ne sont pas décrites plus en détail dans ce document.

Chaque zone active 132 est en contact sur son pourtour extérieur avec la partie de polarisation 133 du nanofil 130 correspondant.

Les parties de polarisation 133 permettent de contacter le nanofil 130 correspondant.

Les parties de polarisation 133 sont préférentiellement composées principalement d'un matériau semiconducteur à gap direct. Chacune des parties de polarisation 133 présente une conductivité du deuxième type.

Pour l'application de l'invention illustrée sur la figure 1, les parties de polarisation 133 présentent chacune une concentration en porteurs majoritaires qui est comprise entre 1.10¹⁷ et 1.10¹⁸ cm⁻³.

Chaque partie de polarisation 133, pour permettre la polarisation de chacun des nanofils 130, est en contact avec le deuxième contact 152.

Le deuxième contact 152 est adapté pour à la fois autoriser une polarisation de chacun des nanofils 130 au niveau de leur partie de polarisation 133 et laisser passer le rayonnement électromagnétique émis ou reçu par les nanofils 130.

Le deuxième contact 152 est une couche d'un matériau conducteur transparent, ou partiellement transparent, à la longueur d'onde émise ou reçue par la structure et qui est adapté pour fournir un contact avec un matériau semiconducteur présentant le deuxième type de conductivité. Ainsi, la couche dont est formé le deuxième contact 152 peut être du nickel-or (Ni-Au), l'oxyde d'indium-étain (ITO) ou tout empilement de ces matériaux (tel que Ni/ITO).

Le deuxième contact 152 forme un deuxième moyen de polarisation adapté pour polariser une partie de chacun des nanofils 130.

La structure 100 comporte également, disposée entre la couche de masquage 142 et la couche constituant le deuxième contact 152, une couche réflectrice 160. Une telle couche réflectrice 160 est une couche adaptée pour réfléchir les rayonnements électromagnétiques à la longueur d'onde pour laquelle est destinée à fonctionner la structure 100.

Dans l'application particulière illustrée sur la figure 1, le matériau de la couche réflectrice 160 est de l'argent (Ag) ou de l'aluminium (Al) avec une épaisseur de la couche supérieure à 50nm et préférentiellement supérieure à 100nm.

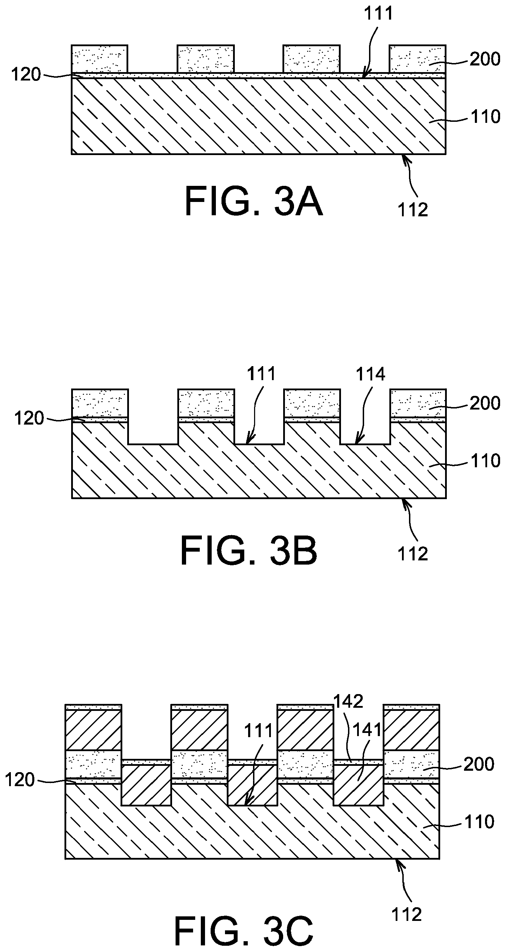

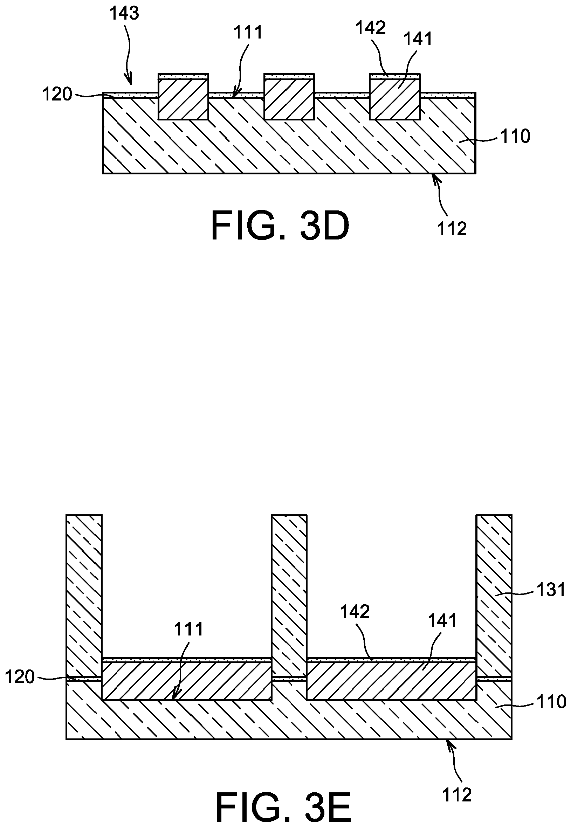

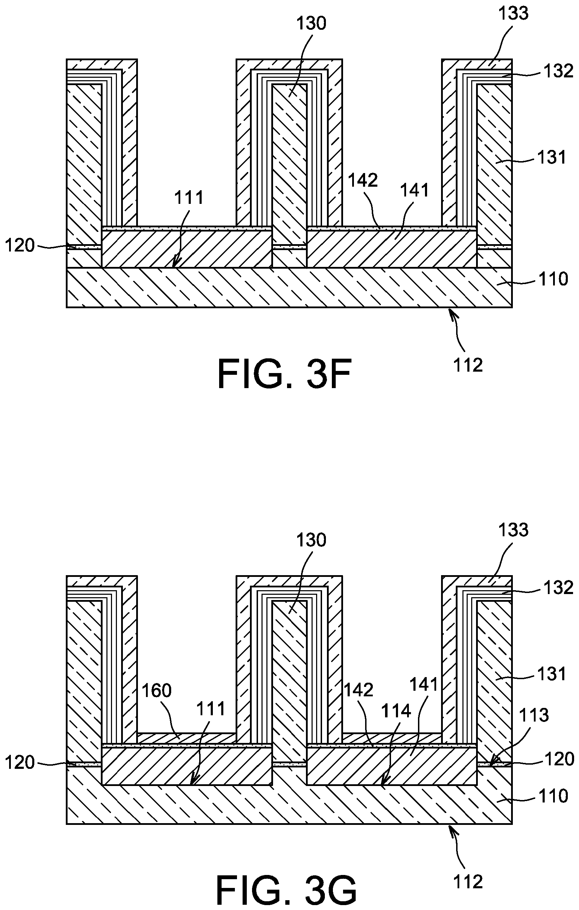

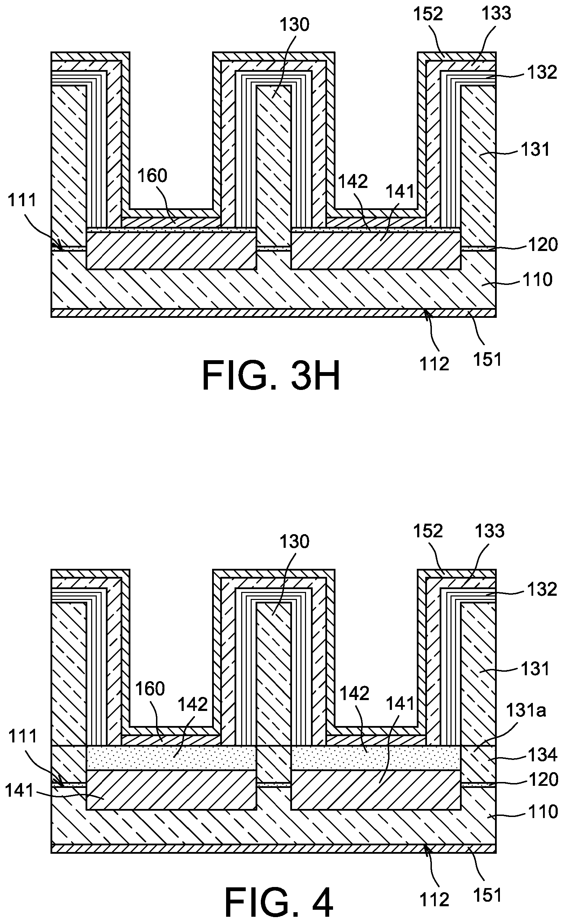

Les figures 3A à 3H illustrent un procédé de fabrication d'une telle structure 100. Un tel procédé de fabrication comporte les étapes consistant à :
- fournir un substrat 110 semiconducteur présentant une première et une seconde face 111, 112,
- former une couche de nucléation 120 en contact sur la première face 111 du substrat 110, ladite couche de nucléation 120,
- déposer une résine 200 photosensible et effectuer, comme illustré sur la figure 3A une opération de lithographie de manière à enlever la partie de la résine qui correspond à la partie libre 114 de la première face 111,
- effectuer une gravure, tel qu'illustré sur la figure 3B, des zones non protégées par la résine 200 de manière à libérer ces zones, correspondant à la partie libre de la première face, de la couche de nucléation et à ce que lesdites zones soient en retrait du reste de la première face 111 d'une profondeur de retrait hᵣₑₜᵣₐᵢₜ, cette étape permettant également de révéler les plots de la couche de nucléation 120,
- déposer sur la partie libre 114 et sur la résine photosensible le matériau constituant la couche conductrice 141,
- déposer, comme illustré sur la figure 3C, la couche de masquage 142 sur la couche conductrice 141,
- retirer la résine 200 photosensible de manière à retirer également la couche conductrice 141 qui n'est pas située au niveau des parties libres 114 ;
- Déposer la couche de masquage 142 sur l'ensemble de la surface,
- Déposer des plots de résine sur les parties de couche conductrice 141 situées au niveau des parties libres 114,
- Graver la couche de masquage 142 pour déboucher sur la couche de nucléation 120.
- former la partie de contact 131 des nanofils 130 au travers des orifices 143 et en contact avec le plot correspondant de la couche de nucléation 120, la partie de contact étant également en contact sur une partie de sa périphérie avec la couche conductrice 141, voir figure 3E,
- former, comme illustré sur la figure 3F, la zone active 132 et la partie polarisation 133 de chacun des nanofils 130, une telle formation permettant de former chaque nanofil,
- déposer, comme illustré sur la figure 3G entre chacun des nanofils 130 une couche réflectrice 160 en contact avec la couche de masquage 142,
- former, comme illustré sur la figure 3H le deuxième contact 152 sur la partie de polarisation des nanofils 130 et la couche réflectrice 160,

Lors de l'étape de dépôt de la couche réflectrice, de couche réflectrice est préférentiellement déposée de manière non conforme. Selon cette possibilité, la partie de la couche 160 en contact avec la couche de masquage 142 est ensuite protégée avec de la résine, afin de graver la partie de la couche 160 déposée à l'extrémité haute du nano-fil. La figure 4 illustre une structure 100 selon un deuxième mode de réalisation. Une structure 100 selon ce deuxième mode de réalisation se différencie d'une structure 100 selon le premier mode de réalisation en ce que chaque nanofil 130 comporte dans sa partie de contact 131 une zone 131a formée à partir d'une couche 2D dite tampon.

La couche tampon est une couche formée préalablement à la croissance sur la couche de nucléation 120 dans un matériau particulièrement adapté pour à la fois la croissance de la partie de contact 131 des nanofils 130 et la formation d'une interface électrique avec cette même partie des nanofils 130 qui présente une résistance réduite. Le matériau constituant la couche tampon 134 est préférentiellement choisi comme étant sensiblement identique à celui du reste de la partie de contact 131 des nanofils 130.

L'épaisseur de la couche tampon 134 est comprise 300nm et 5µm.

La partie libre 114 de la première face 111 est en retrait par rapport au reste de la première face 111 sur une profondeur de retrait hᵣₑₜᵣₐᵢₜ qui est supérieure à l'épaisseur de la couche tampon 134.

Dans ce deuxième mode de réalisation, la hauteur de contact h_{contact} correspond à la hauteur sur laquelle la couche conductrice 141 est en contact avec la zone 131a du nanofil formée dans la couche tampon.

Un procédé de fabrication d'une structure 100 selon ce deuxième mode de réalisation se différencie d'un procédé de fabrication selon le premier mode de réalisation en ce qu'il porte entre l'étape de formation de la couche de nucléation et l'étape de dépôt de la résine photosensible, une étape de formation de la couche tampon.

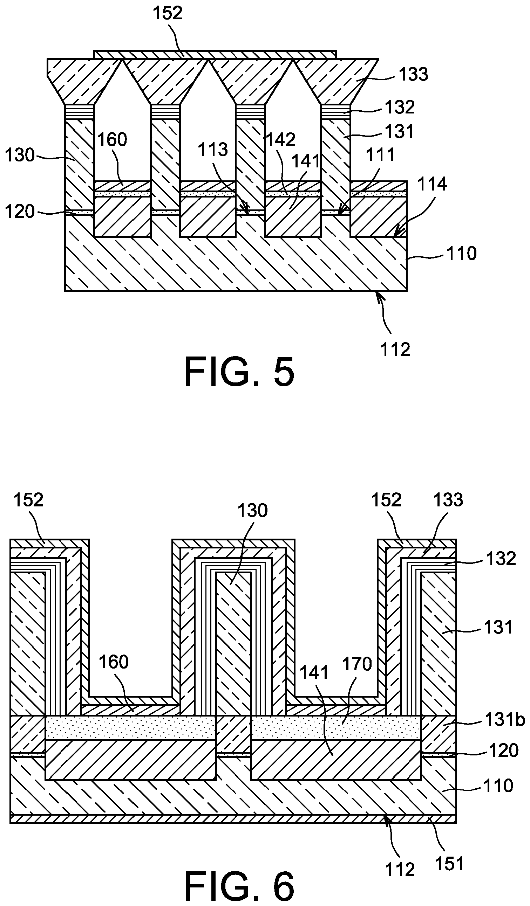

La figure 5 illustre une structure 100 selon un troisième mode de réalisation. Une structure 100 selon ce troisième mode de réalisation se différencie d'une structure 100 selon le premier mode de réalisation en ce que chaque zone active 132 est une zone active du type axial.

De telles zones actives 132 se différencient d'une zone active selon les deux modes de réalisation décrits ci-dessus en ce qu'elles sont dans le prolongement des parties de contact 131 correspondantes et en ce que le contact entre lesdites zones actives 132 et les parties de contact 131 correspondantes est uniquement au niveau de l'extrémité de la partie de contact 131.

Selon cette même possibilité, chaque partie de polarisation 133 est également dans le prolongement de la partie de contact 131 et de la zone active 132 correspondantes, le contact entre chaque partie de polarisation 133 et la zone active 132 correspondante étant uniquement au niveau de l'extrémité de la zone active 132.

Le procédé de fabrication d'une structure 100 selon cette possibilité se différencie du procédé de fabrication d'une structure 100 selon le premier mode de réalisation uniquement par les étapes de formation des nanofils 130 qui sont adaptées pour la formation de nanofils 130 comportant une zone active 132 du type axial.

La figure 6 illustre une structure 100 selon un quatrième mode de réalisation. Une telle structure 100 se différencie d'une structure 100 selon le premier mode de réalisation en ce que la partie de contact 131 de chacun des nanofils 130 comporte une première zone 131a qui est adaptée pour inhiber la croissance latérale des matériaux qui forme le reste 132, 133 du nanofil 130. Une structure 100 selon le quatrième mode de réalisation se différencie également d'une structure selon le premier mode de réalisation en ce qu'elle ne comporte pas de couche de masquage 142 et en ce qu'elle comporte une couche d'isolation 170 disposée entre la couche conductrice 141 et la couche réflectrice 160.

Dans ce mode de réalisation les nanofils 130 sont principalement formés de nitrure semiconducteur. La première zone 131b est une zone de chacun des nanofils 130 qui comporte au niveau de son pourtour une couche d'inhibition (non illustrée), telle que décrite dans la demande de brevet français enregistrée sous le numéro 1152926 formée de nitrure de silicium. Cette couche d'inhibition de quelques nanomètres d'épaisseur permet d'inhiber la croissance latérale sur le pourtour de la première zone de chaque nanofil évitant ceci la croissance de la zone active 132 et de la partie de polarisation 133 sur cette zone. De par sa faible épaisseur, la couche d'inhibition n'affecte pas significativement le contact entre la couche de conduction 141 et le pourtour de la partie de contact du nanofil 130.

La couche d'isolation 170 est une couche en matériau diélectrique, tel que du dioxyde de silicium SiO₂, classiquement utilisé pour isoler les couches électriquement conductrices dans le domaine de la micro-électronique. L'épaisseur de la couche d'isolation 170 est adaptée pour isoler électriquement entre elles la couche conductrice 141 et la couche réflectrice 160 celle-ci étant directement en contact avec le deuxième contact électrique 152.

Le procédé de fabrication d'une structure 100 selon ce quatrième mode de réalisation, se différencie du procédé de fabrication d'une structure 100 selon le premier mode de réalisation en ce qu'il ne comporte pas l'étape de formation de la couche de masquage 142, en ce que l'étape de formation de la partie contact 131 comporte une sous-étape consistant à déposer un nitrure semiconducteur comportant une proportion de silicium de manière à former la première zone 131a de la partie contact 131, et en ce qu'il comprend une étape une étape consistant à former la couche d'isolation 170 sur la couche conductrice 141 avant l'étape de formation de la couche réflectrice 160.

## Revendications

1. Structure (100) semiconductrice optoélectronique comportant :
- un substrat (110) semiconducteur présentant une première et une seconde face (111, 112),
- une couche de nucléation (120) en contact avec la première face (111) du substrat (110), un nanofil (130) en contact avec la couche de nucléation,
la couche de nucléation (120) étant formée d'au moins un plot et recouvrant la première face (111) du substrat (110) sur une partie (113) de la première face (111) qui est dite de nucléation, la partie (114) de la première face (111) non recouverte par la couche de nucléation (120) étant dite partie libre, la structure comportant en outre une couche conductrice (141) en contact avec la partie libre (114) du substrat (110), ladite couche conductrice étant également en contact avec le nanofil sur le pourtour du nanofil (130),
ladite structure étant **caractérisée en ce que** la couche de nucléation est un semiconducteur grand gap dont l'énergie de bande interdite est supérieure à 5 eV, et **en ce que** la partie libre (114) de la première face (111) est en retrait par rapport à la partie de nucléation (113) ceci sur une hauteur de retrait (hᵣₑₜᵣₐᵢₜ) qui est comprise entre 1 nm et 5 µm, la dite hauteur de retrait (hᵣₑₜᵣₐᵢₜ) étant préférentiellement comprise entre 1 nm et 500 nm.

2. Structure (100) selon la revendication 1, dans laquelle le nanofil (130) recouvre sensiblement la totalité de la couche de nucléation (120).

3. Structure (100) selon l'une quelconque des revendications précédentes, dans laquelle le nanofil (130) est en contact sur la couche de nucléation (120) selon un plan sensiblement parallèle à la première face (111) du substrat (100) en présentant une dimension latérale maximale de la zone du nanofil (130) qui est en contact avec la couche de conduction (120), la couche conductrice (141) étant en contact avec le nanofil sur une hauteur de contact qui est au moins égale à la dimension latérale maximale divisée par quatre.

4. Structure (100) selon l'une quelconque des revendications précédentes, dans laquelle la couche conductrice (141) est principalement réalisée en un matériau réfractaire ou un alliage réfractaire.

5. Structure (100) selon l'une quelconque des revendications précédentes, dans laquelle la couche conductrice (141) est principalement réalisée en un matériau sélectionné dans le groupe comportant le titane (Ti), le tungstène (W), le nickel (Ni) et les alliages comportant lesdits métaux.

6. Structure (100) selon l'une quelconque des revendications précédentes, dans laquelle la structure (100) est une structure d'un type sélectionné dans le groupe comportant les structures adaptées pour émettre un rayonnement électromagnétique, les structures adaptées pour recevoir un rayonnement électro-magnétique et le transformer en un signal électrique et les structures du type photovoltaïque.

7. Structure (100) selon l'une quelconque des revendications précédentes, dans laquelle il est en outre prévu un premier contact électrique (151) en contact avec le substrat (110) et un deuxième contact électrique (152) en contact électrique avec le nanofil (130) sur une extrémité de ce dernier qui est opposée au substrat (110), ceci de manière à autoriser une polarisation du nanofil (130).

8. Procédé de fabrication d'une structure (100) semiconductrice optoélectronique comportant au moins un nanofil (130) semiconducteur, ledit procédé comportant les étapes consistant à:
- fournir un substrat (110) semiconducteur présentant une première et une seconde face (111, 112),
- former une couche de nucléation (120) formée d'au moins un plot en contact avec la première face (111) du substrat (110) sur une partie dite de nucléation (113) de cette même première face (111), la partie de la première face (111) non recouverte par la couche de nucléation (120) étant dite partie libre (114),
- former une couche conductrice (141) en contact avec la partie libre (114) de la première face (111),
- former au moins un nanofil (130) avec une partie du nanofil, dite de contact, qui est en contact avec la couche de nucléation (120), le nanofil étant en contact avec la couche conductrice (141) sur son pourtour, la couche de nucléation étant en contact avec la première face (111) du substrat (110),
**caractérisé en ce que** la couche de nucléation est un semiconducteur grand gap dont l'énergie de bande interdite est supérieure à 5 eV, et **en ce que** la partie libre (114) de la première face (111) est en retrait par rapport à la partie de nucléation (113) ceci sur une hauteur de retrait (hᵣₑₜᵣₐᵢₜ) qui est comprise entre 1 nm et 5 µm, la dite hauteur de retrait (hᵣₑₜᵣₐᵢₜ) étant préférentiellement comprise entre 1 nm et 500 nm.

9. Procédé de fabrication selon la revendication 8, dans lequel l'étape de formation de la couche de nucléation (120) comprend les sous-étapes consistant à :
- former une couche de nucléation (120) sur l'ensemble de la première face (111),
- graver sélectivement une partie de la couche nucléation (120) de manière à libérer la partie libre (114) de la première face (111) du substrat (110).

10. Procédé de fabrication selon la revendication 9, dans lequel l'étape de gravure de la partie libre (114) de la première face (111) et la sous-étape de gravure sélective d'une partie de la couche de nucléation (120) sont effectuées lors d'une unique étape de gravure.

11. Procédé de fabrication selon l'une quelconque des revendications 8 à 10, dans lequel l'étape de formation d'au moins un nanofil comprend les sous-étapes consistant à :
- former une couche dite de masquage (142) sur la couche conductrice (141),
- former un orifice dans la couche de masquage (142) et dans une partie de la couche conductrice (141), ledit orifice débouchant sur la couche de nucléation (120) pour révéler le plot,
- former un nanofil par croissance sélective sur le plot de la couche de nucléation (120) sur laquelle débouche le nanofil (130).

12. Procédé de fabrication selon l'une quelconque des revendications 8 à 10, dans lequel l'étape de formation d'au moins un nanofil comprend les sous étapes consistant à :
- former un orifice (143) dans la couche conductrice (141), ledit orifice débouchant sur la couche de nucléation (120) pour révéler le plot,
- former un nanofil (130) par croissance sélective sur le plot de la couche de nucléation (120).

13. Procédé de fabrication selon la revendication 10, dans lequel l'étape de formation d'au moins un nanofil comprend les sous-étapes consistant à :
- former, avant l'étape de gravure de la partie libre (114) de la première face (111) et d'une partie de la couche de nucléation (120), une couche tampon (134) sur la couche de nucléation (120), ladite couche tampon étant gravée avec la couche de nucléation (120) et la partie libre de la première face (111),
- former, après l'étape de formation de la couche conductrice (141), une couche (142) dite de masquage sur la couche conductrice (141),
- former un orifice (143) dans la couche de masquage (142) et dans une partie de la couche conductrice (141), ledit orifice (143) débouchant sur la couche tampon (134),
- former un nanofil (130) par croissance sélective sur la partie de la couche tampon (134) sur laquelle débouche l'orifice (143).

## Patentansprüche

1. Optoelektronische Halbleiterstruktur (100), enthaltend:
- ein Halbleitersubstrat (110) mit einer ersten und einer zweiten Fläche (111, 112),
- eine Keimbildungsschicht (120) in Kontakt mit der ersten Fläche (111) des Substrats (110),
- einen Nanodraht (130) in Kontakt mit der Keimbildungsschicht,
wobei die Keimbildungsschicht (120) aus zumindest einem Pad gebildet ist und die erste Fläche (111) des Substrats (110) über einen Abschnitt (113) der ersten Fläche (111), als Keimbildungsabschnitt bezeichnet, bedeckt, wobei der nicht von der Keimbildungsschicht (120) bedeckte Abschnitt (114) der ersten Fläche (111) als freier Abschnitt bezeichnet wird, wobei die Struktur ferner eine leitende Schicht (141) in Kontakt mit dem freien Abschnitt (114) des Substrats (110) enthält, wobei die leitende Schicht über den Umfang des Nanodrahtes (130) auch in Kontakt mit dem Nanodraht steht,
wobei die Struktur **dadurch gekennzeichnet ist, dass** die Keimbildungsschicht ein Halbleiter mit großer Lücke und einer Bandlückenenergie von mehr als 5 eV ist, und dass der freie Abschnitt (114) der ersten Fläche (111) in Bezug auf den Keimbildungsabschnitt (113) rückspringend ausgebildet ist, und zwar über eine Rücksprunghöhe (h_{Rücksprung}), die zwischen 1 nm und 5 µm liegt, wobei die Rücksprunghöhe (h_{Rücksprung}) vorzugsweise zwischen 1 nm und 500 nm liegt.

2. Struktur (100) nach Anspruch 1, wobei der Nanodraht (130) im Wesentlichen die gesamte Keimbildungsschicht (120) bedeckt.

3. Struktur (100) nach einem der vorhergehenden Ansprüche, wobei der Nanodraht (130) in Kontakt an der Keimbildungsschicht (120) entlang einer im Wesentlichen parallel zu der ersten Fläche (111) des Substrats (100) verlaufenden Ebene steht und dabei eine maximale seitliche Abmessung des Bereichs des Nanodrahts (130) aufweist, der in Kontakt mit der Leitungsschicht (120) steht, wobei die leitende Schicht (141) mit dem Nanodraht über eine Kontakthöhe in Kontakt steht, die zumindest gleich der maximalen seitlichen Abmessung geteilt durch vier ist.

4. Struktur (100) nach einem der vorhergehenden Ansprüche, wobei die leitende Schicht (141) überwiegend aus einem feuerfesten Material oder einer feuerfesten Legierung hergestellt ist.

5. Struktur (100) nach einem der vorhergehenden Ansprüche, wobei die leitende Schicht (141) überwiegend aus einem Material hergestellt ist, das ausgewählt ist aus der Gruppe umfassend Titan (Ti), Wolfram (W), Nickel (Ni) und Legierungen, die diese Metalle enthalten.

6. Struktur (100) nach einem der vorhergehenden Ansprüche, wobei die Struktur (100) eine Struktur eines Typs ist, ausgewählt aus der Gruppe umfassend Strukturen zum Aussenden von elektromagnetischer Strahlung, Strukturen zum Empfangen von elektromagnetischer Strahlung und Umwandeln derselben in ein elektrisches Signal, und Photovoltaik-Strukturen.

7. Struktur (100) nach einem der vorhergehenden Ansprüche, wobei ferner ein erster elektrischer Kontakt (151) in Kontakt mit dem Substrat (110) und ein zweiter elektrischer Kontakt (152) in elektrischem Kontakt mit dem Nanodraht (130) an einem Ende desselben, das dem Substrat (110) gegenüberliegt, so vorgesehen sind, dass eine Polarisierung des Nanodrahtes (130) erfolgen kann.

8. Verfahren zur Herstellung einer optoelektronischen Halbleiterstruktur (100) mit zumindest einem Halbleiter-Nanodraht (130), wobei das Verfahren die folgenden Schritte umfasst:
- Bereitstellen eines Halbleitersubstrats (110) mit einer ersten und einer zweiten Fläche (111, 112),
- Ausbilden einer Keimbildungsschicht (120), die aus zumindest einem Pad in Kontakt mit der ersten Fläche (111) des Substrats (110) über einen sogenannten Keimbildungsabschnitt (113) dieser gleichen ersten Fläche (111) gebildet wird, wobei der nicht von der Keimbildungsschicht (120) bedeckte Abschnitt der ersten Fläche (111) als freier Abschnitt (114) bezeichnet wird,
- Ausbilden einer leitenden Schicht (141) in Kontakt mit dem freien Abschnitt (114) der ersten Fläche (111),
- Ausbilden zumindest eines Nanodrahts (130) mit einem Abschnitt des Nanodrahtes, als Kontaktabschnitt bezeichnet, der in Kontakt mit der Keimbildungsschicht (120) steht, wobei der Nanodraht über seinen Umfang in Kontakt mit der leitenden Schicht (141) steht, wobei die Keimbildungsschicht mit der ersten Fläche (111) des Substrats (110) in Kontakt steht,
**dadurch gekennzeichnet, dass** die Keimbildungsschicht ein Halbleiter mit großer Lücke und einer Bandlückenenergie von mehr als 5 eV ist, und dass der freie Abschnitt (114) der ersten Fläche (111) in Bezug auf den Keimbildungsabschnitt (113) rückspringend ausgebildet ist, und zwar über eine Rücksprunghöhe (h_{Rücksprung}), die zwischen 1 nm und 5 µm liegt, wobei die Rücksprunghöhe (h_{Rücksprung}) vorzugsweise zwischen 1 nm und 500 nm liegt.

9. Herstellungsverfahren nach Anspruch 8, wobei der Schritt des Ausbildens der Keimbildungsschicht (120) die folgenden Teilschritte umfasst:
- Ausbilden einer Keimbildungsschicht (120) über die gesamte erste Fläche (111),
- selektives Ätzen eines Abschnitts der Keimbildungsschicht (120), so dass der freie Abschnitt (114) der ersten Fläche (111) des Substrats (110) freigegeben wird.

10. Herstellungsverfahren nach Anspruch 9, wobei der Schritt des Ätzens des freien Abschnitts (114) der ersten Fläche (111) und der Teilschritt des selektiven Ätzens eines Abschnitts der Keimbildungsschicht (120) in einem einzigen Ätzschritt erfolgen.

11. Herstellungsverfahren nach einem der Ansprüche 8 bis 10, wobei der Schritt des Ausbildens von zumindest einem Nanodraht die folgenden Teilschritte umfasst:
- Ausbilden einer sogenannten Maskierungsschicht (142) auf der leitenden Schicht (141),
- Ausbilden einer Öffnung in der Maskierungsschicht (142) und in einem Abschnitt der leitenden Schicht (141), wobei die Öffnung an der Keimbildungsschicht (120) ausmündet, um das Pad freizulegen,
- Ausbilden eines Nanodrahtes durch selektives Aufwachsen auf dem Pad der Keimbildungsschicht (120), an der der Nanodraht (130) ausmündet.

12. Herstellungsverfahren nach einem der Ansprüche 8 bis 10, wobei der Schritt des Ausbildens von zumindest einem Nanodraht die folgenden Teilschritte umfasst:
- Ausbilden einer Öffnung (143) in der leitenden Schicht (141), wobei die Öffnung an der Keimbildungsschicht (120) ausmündet, um das Pad freizulegen,
- Ausbilden eines Nanodrahtes (130) durch selektives Aufwachsen auf dem Pad der Keimbildungsschicht (120).

13. Herstellungsverfahren nach Anspruch 10, wobei der Schritt des Ausbildens von zumindest einem Nanodraht die folgenden Teilschritte umfasst:
- vor dem Schritt des Ätzens des freien Abschnitts (114) der ersten Fläche (111) und eines Abschnitts der Keimbildungsschicht (120), Ausbilden einer Pufferschicht (134) auf der Keimbildungsschicht (120), wobei die Pufferschicht mit der Keimbildungsschicht (120) und dem freien Abschnitt der ersten Fläche (111) geätzt wird,
- nach dem Schritt des Ausbildens der leitenden Schicht (141), Ausbilden einer sogenannten Maskierungsschicht (142) auf der leitenden Schicht (141),
- Ausbilden einer Öffnung (143) in der Maskierungsschicht (142) und in einem Abschnitt der leitenden Schicht (141), wobei die Öffnung (143) an der Pufferschicht (134) ausmündet,
- Ausbilden eines Nanodrahts (130) durch selektives Aufwachsen auf dem Abschnitt der Pufferschicht (134), an dem die Öffnung (143) ausmündet.

## Claims

1. An optoelectronic semiconductor structure (100) including:
- a semiconductor substrate(110) having a first and second face (111, 112),
- a nucleation layer (120) in contact with the first face (111) of the substrate (110),
- a nanowire (130) in contact with the nucleation layer,
the nucleation layer (120) being formed from at least one pad and covering the first face (111) of the substrate (110) over a portion (113) of the first face (111), called the "nucleation" face, where the portion (114) of the first face (111) which is not covered by the nucleation layer (120) is called the "free" portion, where the structure also includes a conducting layer (141) in contact with the free portion (114) of the substrate (110), and the said conducting layer being also in contact with the nanowire on the perimeter of the nanowire (130).
Said structure being **characterized in that** the nucleation layer is an wide-gap semiconductor with a forbidden energy band higher than 5 eV and **in that** the free portion (114) of the first face (111) is recessed relative to the nucleation portion (113), over a recess height (h_{recess}) which is between 1nm and 5µm, and where the said recess height (h_{recess}) is preferentially between 1nm and 500nm.

2. A structure (100) according to claim 1, in which the nanowire (130) covers roughly the entire nucleation layer (120).

3. A structure according to any one from the preceding claims, in which the nanowire (130) is in contact on the nucleation layer (120) in a plane which is roughly parallel to the first face (111) of the substrate (100), having a maximum lateral dimension of the zone of the nanowire (130) which is in contact with the conduction layer (120), where the conducting layer (141) is in contact with the nanowire over a contact height which is at least equal to the maximum lateral dimension divided by four.

4. A structure (100) according to any one from the preceding claims, in which the conducting layer (141) is made principally from a refractory material or a refractory alloy.

5. A structure (100) according to any one from the preceding claims, in which the conducting layer (141) is principally made from a material selected from the group containing titanium (Ti), tungsten (W), nickel (Ni) and alloys containing the said metals.

6. A structure (100) according to any one from the preceding claims, in which the structure (100) is a structure of a type selected from the group including structures able to emit electromagnetic radiation, structures able to receive electromagnetic radiation and to transform it into an electrical signal, and structures of the photovoltaic type.

7. A structure (100) according to any one from the preceding claims, in which the structure further comprises a first electrical contact (151) in contact with the substrate (110) and a second electrical contact (152) in contact with the nanowire (130) on a extremity of the nanowire that is in the opposite of the substrate (110), in such way to allow a polarization of the nanowire (130).

8. A method of manufacture of an optoelectronic semiconductor structure (100) including at least one semiconducting nanowire (130), where the said method includes the steps consisting in:
- providing a semiconductor substrate (110) having a first and second face (111, 112),
- forming a nucleation layer (120), formed from at least one pad in contact with the first face (111) of the substrate (110) over a portion, called the "nucleation" portion (113), of this same first face (111), and where the portion of the first face (111) which is not covered by the nucleation layer (120) is called the "free" portion (114),
- forming a conducting layer (141) in contact with the free portion (114) of the first face (111),
- forming at least one nanowire (130) with a portion of the nanowire, called the "contact" nanowire, which is in contact with the nucleation layer (120), and where the nanowire is in contact with the conducting layer (141) over its perimeter,
being **characterized in that** the nucleation layer is an wide-gap semiconductor with a forbidden energy band higher than 5 eV and **in that** the free portion (114) of the first face (111) is recessed relative to the nucleation portion (113), over a recess height (h_{recess}) which is between 1nm and 5µm, and where the said recess height (h_{recess}) is preferentially between 1nm and 500nm..

9. A method of manufacture according to claim 8, in which the step of formation of the nucleation layer (120) includes the sub-steps consisting in:
- forming a nucleation layer (120) over the entire first face (111),
- selectively etching a portion of the nucleation layer (120) so as to release the free portion (114) of the first face (111) of the substrate (110).

10. A method of manufacture according to claims 10 and 11, in which the step of etching of the free portion (114) of the first face (111) and the sub-step of selective etching of a portion of the nucleation layer (120) can be undertaken during a single etching step.

11. A method of manufacture according to claims 9 to 12, in which the step of formation of at least one nanowire includes the sub-steps consisting in:
- forming a layer called the "masking" layer (142) on the conducting layer (141),
- forming an aperture in the masking layer (142) and in a portion of the conducting layer (141), where the said aperture emerges in the nucleation layer (120) to reveal the pad,
- forming a nanowire by selective growing on the pad of the nucleation layer (120) in which nanowire (130) emerges.

12. A method of manufacture according to claims 9 to 12, in which the step of formation of at least one nanowire includes the sub-steps consisting in:
- forming an aperture (143) in the conducting layer (141), where the said aperture emerges in the nucleation layer (120) to reveal the pad,
- forming a nanowire (130) by selective growing on the pad of the nucleation layer (120).

13. A method of manufacture according to claim 14, in which the step of formation of at least one nanowire includes the sub-steps consisting in:
- forming, before the step of etching of the free portion (114) of the first face (111) and of a portion of the nucleation layer (120), a buffer layer (134) on the nucleation layer (120), where the said buffer layer is etched with the nucleation layer (120) and the free portion of the first face (111),
- forming, after the step of formation of the conducting layer (141), a layer (142) called the "masking" layer on the conducting layer (141),
- forming an aperture (143) in the masking layer (142) and in a portion of the conducting layer (141), where the said aperture (143) emerges in the buffer layer (134),
- forming a nanowire (130) by selective growing on the portion of the buffer layer (134) in which the aperture (143) emerges.
